# FASCICULE DE BREVET EUROPEEN

(11) **EP 0 768 533 B1**
(45) Date de publication et mention de la délivrance du brevet: **12.06.2002**
(21) Numéro de dépôt: 96402144.8
(22) Date de dépôt: 10.10.1996
(51) Int. Cl.: G01P 15/09

(54) **Amplificateur de charge différentiel pour capteur piézoélectrique**
Differentieller Ladungsverstärker für piezoelektrischen Messaufnehmer
Differential charge amplifier for piezoelectric sensor

(30) Priorité: 11.10.1995 FR 9511905
(43) Date de publication de la demande: 16.04.1997
(73) Titulaire: SOCIETE NATIONALE D'ETUDE ET DE CONSTRUCTION DE MOTEURS D'AVIATION -Snecma, F-75015 Paris (FR)
(72) Inventeur: Vanoli, Joel Marc, 95120 Ermont (FR)

(56) Documents cités:
- EP-A- 0 538 976
- DE-A- 3 918 407
- ELECTRONICS, vol. 41, no. 19, 16 Septembre 1968, NEW-YORK, pages 105-108, XP002006390 DE PIAN ET AL: "ACTIVE FILTERS: PART 4; APPROACHING THE IDEAL NIC"

## Description

L'invention concerne un amplificateur de charge différentiel pour capteur piézoélectrique. Elle peut s'appliquer à tous les dispositifs utilisant des capteurs piézoélectriques et notamment à un dispositif de mesure des vibrations d'un moteur au moyen d'un accéléromètre piézoélectrique.

Il est connu, notamment du document EP-A-0 538 976, de mesurer les vibrations d'un moteur au moyen d'un capteur piézoélectrique associé à un amplificateur de charge, l'amplificateur de charge étant destiné à convertir en tension la charge électrique délivrée par le capteur piézoélectrique. Dans le cas d'une instrumentation sur un moteur ou dans un milieu industriel, un signal parasite appelé tension de mode commun, se superpose généralement au signal à mesurer. L'élimination de ce signal parasite est obtenue en choisissant une structure différentielle comportant un capteur piézoélectrique différentiel associé à un amplificateur de charge différentiel. Les amplificateurs de charge différentiels connus comportent généralement deux amplificateurs opérationnels montés en intégrateurs et nécessitent un appariement rigoureux de deux condensateurs d'intégration, ce qui ne peut être obtenu qu'après un tri long et coûteux de composants.

Le but de l'invention est de réaliser un amplificateur de charge différentiel permettant de convertir en tension la charge électrique délivrée par un capteur piézoélectrique différentiel au moyen d'un dispositif intégrateur n'utilisant qu'un seul condensateur d'intégration, tout en assurant la réjection d'une tension de mode commun éventuellement superposée au signal utile à mesurer.

Pour cela, conformément à l'invention, l'amplificateur de charge différentiel comporte des moyens de soustraction permettant d'effectuer la différence entre deux courants de mesure délivrés par le capteur différentiel, et des moyens d'intégration ne comportant qu'un seul condensateur d'intégration pour intégrer le signal délivré par les moyens de soustraction.

Selon un premier mode de réalisation de l'invention, les moyens de soustraction comportent un convertisseur d'impédance à imittance négative, connu sous le nom de "INIC" et les moyens d'intégration sont constitués par un amplificateur opérationnel monté en intégrateur.

Selon un deuxième mode de réalisation de l'invention, les moyens de soustraction et d'intégration sont constitués par un amplificateur de courant différentiel chargé par un condensateur d'intégration.

Selon l'invention, l'amplificateur de charge différentiel pour capteur piézoélectrique différentiel est caractérisé en ce qu'il comporte des moyens de soustraction destinés à effectuer la différence entre deux courants de mesure délivrés par les deux sorties du capteur piézoélectrique différentiel et des moyens d'intégration destinés à intégrer le courant délivré par les moyens de soustraction et à délivrer une tension de sortie proportionnelle à un signal utile mesuré par le capteur piézoélectrique.

D'autres particularités et avantages de l'invention apparaitront clairement dans la suite de la description donnée à titre d'exemple non limitatif et faite en regard des figures annexées qui représentent :
- la figure 1, un circuit électrique d'un ensemble constitué par un capteur piézoélectrique différentiel associé à un amplificateur de charge différentiel, selon un premier mode de réalisation de l'invention ,
- la figure 2, un circuit électrique d'un ensemble constitué par un capteur piézoélectrique différentiel associé à un amplificateur de charge différentiel selon un deuxième mode de réalisation de l'invention.

Un capteur piézoélectrique peut être représenté par un schéma électrique équivalent comportant une source de tension alternative connectée en série avec un condensateur. La charge électrique délivrée par le capteur piézoélectrique est proportionnelle à l'accélération à mesurer, le coefficient de proportionnalité étant égal à la sensibilité du capteur.

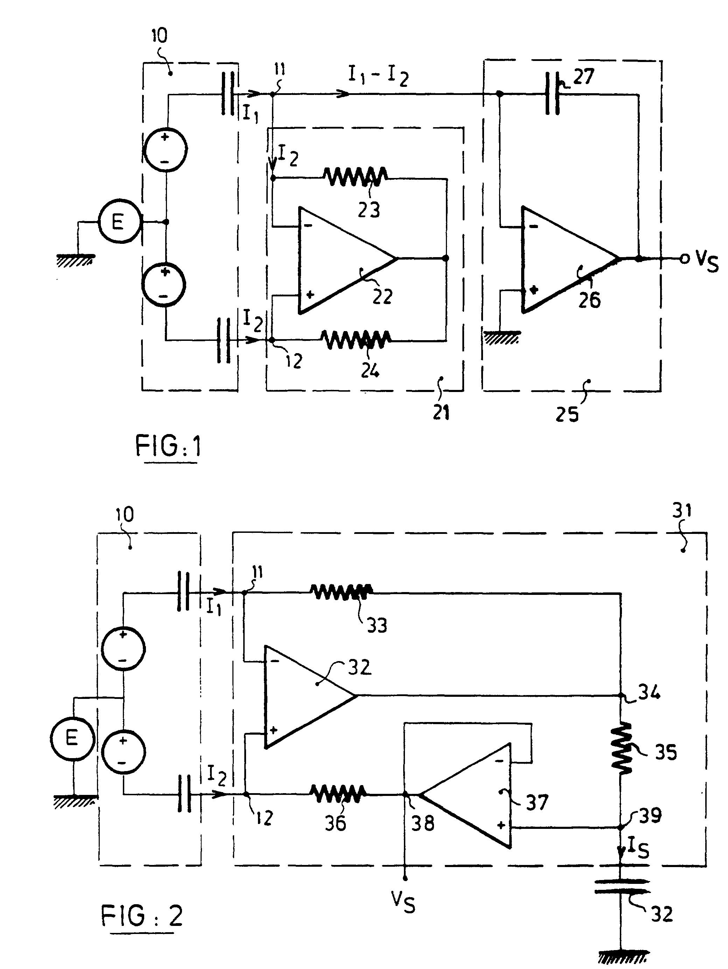

La figure 1 représente un circuit électrique d'un ensemble constitué par un capteur piézoélectrique différentiel associé à un amplificateur de charge différentiel, selon un premier mode de réalisation de l'invention.

Le circuit électrique représenté sur la figure 1 correspond au cas où une tension de mode commun est superposée au signal à mesurer. La tension de mode commun est représentée par une source de tension alternative E connectée entre la masse et le capteur piézoélectrique différentiel. Le capteur piézoélectrique 10 comporte deux voies de mesure en parallèle, chaque voie de mesure comportant une source de tension alternative connectée en série avec un condensateur. Les sources de tension et les condensateurs des deux lignes de mesure ont respectivement les mêmes valeurs.

Les charges électriques mesurées par les deux voies de mesure du capteur piézoéléctrique différentiel 10 sont respectivement représentées par deux courants I1 et I2 dont la différence I1-I2 correspond au signal utile. Les deux courants I1 et I2 sont délivrés respectivement sur deux sorties 11, 12 du capteur 10, les deux sorties 11, 12 étant connectées sur deux entrées de l'amplificateur de charge différentiel.

L'amplificateur de charge différentiel comporte un inverseur de courant 21 comportant une borne d'entrée et une borne de sortie connectées respectivement aux deux bornes de sorties 11, 12 du capteur 10, et un intégrateur 25 relié à la borne de sortie 11 du capteur 10 et destiné à délivrer une tension de sortie VS proportionnelle à l'accélération à mesurer. L'inverseur de courant 21 est destiné à délivrer sur sa borne de sortie l'image négative du courant I2 présenté sur son entrée. Le point de connexion entre la sortie 11 du capteur, la sortie de l'inverseur de courant 21 et l'entrée de l'intégrateur 25 constitue un noeud de Kirchoff. Par application de la loi de Kirchoff, le courant appliqué en entrée de l'intégrateur 25 est égal la différence I1-I2 entre le courant I1 délivré par la sortie 11 du capteur 10 et l'image négative du courant I2 délivrée en sortie de l'inverseur de courant 21.

L'inverseur de courant 21 est constitué par un convertisseur d'impédance à immitance négative connu sous le nom de INIC et comporte un amplificateur opérationnel 22 associé à deux résistances 23, 24 de valeur égale. Les résistances 23, 24 sont connectées entre une entrée inverseuse, respectivement une entrée non inverseuse, et la sortie de l'amplificateur 22. Les deux résistances 23, 24 étant de valeurs égales, le courant délivré en sortie de l'inverseur de courant 21 est l'image négative du courant I2 présenté sur son entrée.

L'intégrateur 25 comporte un amplificateur opérationnel 26 associé à un condensateur 27 connecté entre la sortie et l'entrée inverseuse de l'amplificateur 26. L'entrée non inverseuse de l'amplificateur 26 est connectée à la masse.

La différence de courant I1-I2 est appliquée sur l'entrée non inverseuse de l'amplificateur 26 et intégrée par le condensateur 27. La tension VS délivrée en sortie de l'intégrateur 25 est proportionnelle à l'accélération mesurée par le capteur 10, le signal de mode commun ayant été éliminé par l'appariement des deux résistances 23, 24 de l'inverseur de courant 21.

La figure 2 représente un circuit électrique d'un ensemble constitué par un capteur piézoélectrique différentiel associé à un amplificateur de charge différentiel, selon un deuxième mode de réalisation de l'invention. Le capteur piézoélectrique différentiel 10 est représenté par le même schéma électrique équivalent que sur la figure 1, et une tension E de mode commun est superposée au signal utile à mesurer.

L'amplificateur de charge 30 comporte un amplificateur de courant différentiel 31 chargé par un condensateur d'intégration 32. L'amplificateur de courant différentiel 31 est destiné à élaborer un courant IS égal à la différence I1-I2 des courants délivrés par les deux sorties 11, 12 du capteur 10. Cette différence de courant est ensuite intégrée par le condensateur d'intégration 32 destiné à délivrer à ses bornes une tension proportionnelle à l'accélération à mesurer.

L'amplificateur de courant différentiel 31 comporte un amplificateur opérationnel 32 ayant une entrée inverseuse connectée sur la sortie 11 du capteur 10 et une entrée non inverseuse connectée sur la sortie 12 du capteur 10. Une résistance 33 est connectée entre la sortie 34 et l'entrée inverseuse de l'amplificateur 32. Entre la sortie 34 et l'entrée non inverseuse de l'amplificateur 32 sont connectées deux résistances 35, 36, ces deux résistances étant isolées en courant par un amplificateur suiveur 37 qui recopie sur sa sortie 38, la tension qui est appliquée sur son entrée 39.

La résistance 36 connectée entre la sortie 38 de l'amplificateur suiveur 37 et l'entrée non inverseuse de l'amplificateur opérationnel 32 est de même valeur que la résistance 33. La résistance 35 connectée entre la sortie 34 de l'amplificateur opérationnel 32 et l'entrée 39 de l'amplificateur suiveur 37 peut avoir une valeur différente de celle des deux résistances 33, 36.

Le condensateur d'intégration 32 est connecté entre un noeud de connexion 39 et la masse, le noeud 39 étant localisé entre la résistance 35 et l'amplificateur suiveur 37. Le condensateur 32 est destiné à intégrer le courant IS qui circule dans la résistance 35.

Le courant IS est égal à la différence I1-I2 des courants délivrés par les deux sorties 11, 12 du capteur 10 et la tension aux bornes du condensateur 32 est proportionnelle à l'accélération mesurée par le capteur 10, le signal de mode commun ayant été éliminé par l'appariement des deux résistances 33, 36 de l'amplificateur de courant différentiel 31.

La tension VS mesurée en sortie de l'amplificateur de charge est prélevée à basse impédance en sortie de l'amplificateur suiveur 37 de manière à ne pas perturber le fonctionnement de l'ensemble du dispositif.

## Revendications

1. Amplificateur de charge différentiel pour capteur piézoélectrique différentiel, l'amplificateur de charge comportant deux entrées destinées à être raccordées sur deux sorties (11, 12) du capteur piézoélectrique (10), **caractérisé en ce qu'**il comporte des moyens de soustraction (21, 31) destinés à effectuer la différence entre deux courants de mesure délivrés par les deux sorties du capteur piézoélectrique différentiel (10), et des moyens d'intégration (25, 32) destinés à intégrer le courant délivré par les moyens de soustraction et à délivrer une tension de sortie proportionnelle à un signal utile mesuré par le capteur piézoélectrique (10).

2. Amplificateur de charge différentiel selon la revendication 1, **caractérisé en ce que** les moyens de soustraction comportent un inverseur de courant (21) ayant une entrée connectée sur une première entrée de l'amplificateur de charge et une sortie connectée en un noeud de Kirchoff raccordé d'une part sur une deuxième entrée de l'amplificateur de charge et d'autre part en entrée des moyens d'intégration (25).

3. Amplificateur de charge différentiel selon la revendication 2, **caractérisé en ce que** l'inverseur de courant (21) est un convertisseur d'impédance à immitance négative comportant un amplificateur opérationnel (22) associé à deux résistances (23, 24) de valeurs identiques.

4. Amplificateur de charge différentiel selon l'une quelconque des revendications 2 ou 3, **caractérisé en ce que** les moyens d'intégration (25) comportent un amplificateur opérationnel (26) associé à un condensateur d'intégration (27).

5. Amplificateur de charge différentiel selon la revendication 1, **caractérisé en ce que** les moyens de soustraction sont constitués par un amplificateur de courant différentiel (31) comportant deux entrées connectées respectivement aux deux entrées de l'amplificateur de charge et **en ce que** les moyens d'intégration sont constitués par un condensateur (32).

6. Amplificateur de charge différentiel selon la revendication 5, **caractérisé en ce que** l'amplificateur de courant différentiel (31) comporte un amplificateur opérationnel (32) ayant une entrée inverseuse et une entrée non inverseuse connectées respectivement sur les deux entrées de l'amplificateur de charge, une première résistance (33) connectée entre une sortie (34) et l'entrée inverseuse de l'amplificateur (32), une deuxième et une troisième résistance (35, 36) connectées entre la sortie (34) et l'entrée non inverseuse de l'amplificateur (32), les deux résistances (35, 36) étant isolées en courant par un amplificateur suiveur (37).

7. Amplificateur de charge différentiel selon la revendication 6, **caractérisé en ce que** la première et la troisième résistance (33, 36) ont des valeurs identiques.

8. Amplificateur de charge différentiel selon la revendication 7, **caractérisé en ce que** le condensateur (32) est connecté entre un noeud de connexion (39) et la masse, le noeud (39) étant localisé entre la résistance (35) et l'amplificateur suiveur (37).

## Patentansprüche

1. Differentieller Ladungsverstärker für piezoelektrische Messaufnehmer, wobei der Ladungsverstärker zwei Eingänge aufweist, die dazu vorgesehen sind, mit zwei Ausgängen (11, 12) des piezoelektrischen Messaufnehmers (10) verbunden zu werden,
**dadurch gekennzeichnet,**
**dass** er Subtraktionsmittel (21, 31) aufweist, die dazu vorgesehen sind, die Differenz zwischen zwei von den zwei Ausgängen des differentiellen piezoelektrischen Messaufnehmers (10) abgegebenen Messströmen zu bestimmen, sowie Integrationsmittel (25, 32) aufweist, die dazu vorgesehen sind, den von den Subtraktionsmitteln abgegebenen Strom zu integrieren und eine Ausgangsspannung abzugeben, die proportional zu einem von dem piezoelektrischen Messaufnehmer (10) gemessenen Nutzsignal ist.

2. Differentieller Ladungsverstärker nach Anspruch 1,
**dadurch gekennzeichnet,**
**dass** die Subtraktionsmittel einen Strominverter (21) mit einem Eingang, der mit einem ersten Eingang des Ladungsverstärkers verbunden ist, und mit einem Ausgang, der in einem Kirchhoffschen Knoten einerseits mit einem zweiten Eingang des Ladungsverstärkers und andererseits mit dem Eingang von Integrationsmitteln (25) verbunden ist, aufweisen.

3. Differentieller Ladungsverstärker nach Anspruch 2,
**dadurch gekennzeichnet,**
**dass** der Strominverter (21) ein Impedanzwandler mit negativer Immittanz ist, der einen Operationsverstärker (22) aufweist, der mit zwei Widerständen (23, 24) mit gleichen Werten verbunden ist.

4. Differentieller Ladungsverstärker nach einem der Ansprüche 2 oder 3,
**dadurch gekennzeichnet,**
**dass** die Integrationsmittel (25) einen Operationsverstärker (26) aufweisen, der mit einem Integrationskondensator (27) verbunden ist.

5. Differentieller Ladungsverstärker nach Anspruch 1,
**dadurch gekennzeichnet,**
**dass** die Subtraktionsmittel von einem differentiellen Stromverstärker (31) gebildet werden, der zwei Eingänge aufweist, die mit den entsprechenden zwei Eingängen des Ladungsverstärkers verbunden sind, und dass die Integrationsmittel aus einem Kondensator (32) bestehen.

6. Differentieller Ladungsverstärker nach Anspruch 5,
**dadurch gekennzeichnet,**
**dass** der differentielle Stromverstärker (31) einen Operationsverstärker (32) aufweist, der einen invertierenden Eingang und einen nicht invertierenden Eingang aufweist, die entsprechend mit den beiden Eingängen des Ladungsverstärkers verbunden sind, sowie einen ersten Widerstand 33 aufweist, der zwischen einem Ausgang (34) und dem invertierenden Eingang des Verstärkers (32) geschaltet ist, sowie einen zweiten und einen dritten Widerstand (35, 36) aufweist, die zwischen dem Ausgang (34) und dem nicht invertierenden Eingang des Verstärkers (32) geschaltet sind, wobei die beiden Widerstände (35, 36) strommäßig durch einen Folgeverstärker (37) getrennt sind.

7. Differentieller Ladungsverstärker nach Anspruch 6,
**dadurch gekennzeichnet,**
**dass** der erste und der dritte Widerstand (33, 36) gleiche Werte haben.

8. Differentieller Ladungsverstärker nach Anspruch 6,
**dadurch gekennzeichnet,**
**dass** der Kondensator (32) zwischen einem Verbindungsknoten (39) und der Masse geschaltet ist, wobei der Knoten (39) sich zwischen dem Widerstand (35) und dem Folgeverstärker (37) befindet.

## Claims

1. Differential charge amplifier for differential piezoelectric sensor, the charge amplifier comprising two inputs intended to be hooked up to two outputs (11, 12) of the piezoelectric sensor (10), **characterized in that** it comprises subtraction means (21, 31) intended to yield the difference between two measurement currents delivered by the two outputs of the differential piezoelectric sensor (10), and integration means (25, 32) intended to integrate the current delivered by the subtraction means and to deliver an output voltage proportional to a useful signal measured by the piezoelectric sensor (10).

2. Differential charge amplifier according to Claim 1, **characterized in that** the subtraction means comprise a current inverter (21) having an input connected to a first input of the charge amplifier and an output connected as a Kirchoff node linked on the one hand to a second input of the charge amplifier and on the other hand as input of the integration means (25).

3. Differential charge amplifier according to Claim 2, **characterized in that** the current inverter (21) is a negative-immittance impedance converter comprising an operational amplifier (22) associated with two resistors (23, 24) of identical values.

4. Differential charge amplifier according to either of Claims 2 or 3, **characterized in that** the integration means (25) comprise an operational amplifier (26) associated with an integration capacitor (27).

5. Differential charge amplifier according to Claim 1, **characterized in that** the subtraction means consist of a differential current amplifier (31) comprising two inputs connected respectively to the two inputs of the charge amplifier and **in that** the integration means consist of a capacitor (32).

6. Differential charge amplifier according to Claim 5, **characterized in that** the differential current amplifier (31) comprises an operational amplifier (32) having an inverting input and a noninverting input connected respectively to the two inputs of the charge amplifier, a first resistor (33) connected between an output (34) and the inverting input of the amplifier (32), a second and a third resistor (35, 36) connected between the output (34) and the noninverting input of the amplifier (32), the two resistors (35, 36) being current-isolated by a follower amplifier (37).

7. Differential charge amplifier according to Claim 6, **characterized in that** the first and the third resistor (33, 36) have identical values.

8. Differential charge amplifier according to Claim 7, **characterized in that** the capacitor (32) is connected between a connection node (39) and earth, the node (39) being located between the resistor (35) and the follower amplifier (37).
